(19) Europäisches Patentamt
European Patent Office
Office européen des brevets

(11) Veröffentlichungsnummer: **0 355 644**
**A2**

(12) # EUROPÄISCHE PATENTANMELDUNG

(21) Anmeldenummer: **89114977.5**

(51) Int. Cl.4: **H01B 1/12**

(22) Anmeldetag: **12.08.89**

(30) Priorität: **25.08.88 DE 3828758**

(43) Veröffentlichungstag der Anmeldung:
**28.02.90 Patentblatt 90/09**

(84) Benannte Vertragsstaaten:
**AT CH DE FR GB IT LI NL SE**

(71) Anmelder: **BAYER AG**

**D-5090 Leverkusen 1 Bayerwerk(DE)**

(72) Erfinder: **Weimann, Norbert, Dr.**
**Heymannstrasse 32**
**D-5090 Leverkusen 1(DE)**
Erfinder: **Jonas, Friedrich, Dr.**
**Krugenofen 15**
**D-5100 Aachen(DE)**
Erfinder: **Giesecke, Henning, Dr.**
**Düsseldorfer Strasse 49**
**D-5000 Köln 80(DE)**

(54) **Verfahren zur Erzeugung elektrisch leitender Schichten auf Substraten und in dem Verfahren zu verwendende Druckpasten.**

(57) Erfindungsgemäß werden elektrisch leitende Schichten von TCNQ-Komplexsalzen auf Substraten erzeugt, in dem man diese mit schmelzbare TCNQ-Komplexsalze enthaltenden Druckpasten beschichtet, die als Bindemittel physikalisch trocknende Bindemittel enthalten und in denen das Gewichtsverhältnis TCNQ-Komplexsalze/Bindemittel >5 ist und die aufgedruckten Schichten nach dem Entfernen der organischen Lösungsmittel kurz aufschmilzt und anschließend durch Abkühlen wieder verfestigt. Die Erfindung betrifft ferner die für die Beschichtung verwendeten Druckpasten.

EP 0 355 644 A2

## Verfahren zur Erzeugung elektrisch leitender Schichten auf Substraten und in dem Verfahren zu verwendende Druckpasten

Die Erfindung betrifft ein neues Verfahren zur Erzeugung von den elektrischen Strom leitenden, gegebenenfalls geometrisch geformten Schichten auf festen Substraten durch Bedrucken der Substrate mit TCNQ-Komplexsalze enthaltenden Druckpasten und die in diesem Verfahren zu verwendenden Druckpasten.

Elektrisch leitfähige TCNQ-Komplexsalze und ihre Verwendung zur Erzeugung elektrisch leitfähiger Schichten auf den elektrischen Strom nicht leitenden Substraten sind bekannt (siehe z.B.: (a) DE-A 36 17 268; (b) US-A 4 580 855; (c) EP-A 0 236 842; (d) EP-B 0 183 977; (e) JA-A 75/56 593 (Ref. CA 83, 156 742 t)).

Das Aufbringen der TCNQ-Komplexsalze bereitet wegen ihrer schlechten Verarbeitungseigenschaften (Schwerlöslichkeit in Lösungsmitteln, geringe Stabilität im schmelzflüssigen Zustand) erhebliche Schwierigkeiten; deshalb wurden bereits verschiedene Verfahren zur Erzeugung von Schichten von TCNQ-Komplexsalzen auf nicht leitenden Substraten vorgeschlagen; aber diese Verfahren befriedigen aus verschiedenen Gründen bislang nicht. So ist in (a) ein Verfahren zur Erzeugung von elektrisch leitenden, TCNQ-Komplexsalze enthaltenden Schichten beschrieben, gemäß dem die Substrate durch Bestreichen oder Begießen mit organische Bindemittel enthaltenden Lösungen von TCNQ-Komplexsalzen in organischen Lösungsmitteln beschichtet werden und anschließend das Lösungsmittel aus der Schicht entfernt wird. Die elektrische Leitfähigkeit der so erhaltenen Beschichtungen reicht zwar für eine antistatische Ausrüstung der Substrate aus, ist aber für eine Verwendung der Schichten als elektrische Leiter, z.B. in gedruckten Schaltungen, unzureichend.

Gemäß (b) werden elektrisch leitfähige Schichten von TCNQ-Komplexsalzen auf festen Substraten erzeugt, indem man diese in die Schmelze von TCNQ-Komplexen eintaucht (Tauchschmelzverfahren). Dieses Verfahren hat den Nachteil, da die TCNQ-Komplexsalze in geschmolzenem Zustand nur kurze Zeit stabil sind, daß die Schmelzen äußerst schnell verarbeitet, d.h. aufgebracht, werden müssen und daß deshalb mit ihm kompliziert geformte geometrische Schichten hoher elektrischer Leitfähigkeit nicht herstellbar sind, wie sie z.B. auf dem Gebiet der Elektronik und Elektrotechnik verlangt werden.

In (c) und (d) ist die Beschichtung von Substraten mit Schmelzen von TCNQ-Komplexsalzen beschrieben, denen zur Herabsetzung des Schmelzpunktes kleine Mengen bestimmter organischer Verbindungen zugesetzt wurden. Die Beschichtung erfolgt durch Aufbringen der schmelzflüssigen Gemische (c) oder durch Aufbringen des festen pulvrigen Gemiches und Aufschmelzen desselben auf dem Substrat. Auch nach dieser Arbeitsweise sind aus den unter (b) erläuterten Gründen keine kompliziert geformten geometrischen Schichten hoher elektrischer Leitfähigkeit erhältlich.

Gemäß (e) werden elektrisch leitfähige Schichten von TCNQ-Komplexen auf Substraten erzeugt, indem man diese im Siebdruck mit verdickten Lösungen beschichtet, die durch Dispergieren von TCNQ-Komplexsalzen in bei Raumtemperatur vernetztenden Siliconharzen und Verdünnen der Dispersionen mit organischen Lösungsmitteln erhalten werden. Mit Hilfe des Verfahrens sind zwar kompliziert geformte geometrische Schichten erhältlich, aber die Leitfähigkeit dieser Schichten ist wegen ihres geringen Gehaltes an TCNQ-Komplexsalzen für eine Verwendung der beschichteten Substrate in die Elektrotechnik oder der Elektronik zu niedrig.

Es bestand daher die Aufgabe, ein Verfahren aufzufinden, mit dem es gelingt mit TCNQ-Komplexsalzen auf Substraten, est haftende, auch kompliziert geformte Schichten mit hoher elektrischer Leitfähigkeit zu erzeugen.

Es wurde gefunden, daß man TCNQ-Komplexsalzschichten auch in komplizierten geometrischen Formen mit den gewünschten Eigenschaften - gute Haftfestigkeit und hohe elektrische Leitfähigkeit - präzis und reproduzierbar auf Substraten erhält, wenn man die TCNQ-Komplexsalze in bestimmter Weise zu Pasten formuliert, die Oberfläche des zu beschichtenden Substrates mit diesen Druckpasten beschichtet und die so erhaltenen Schichten nach dem Entfernen des organischen Lösungsmittels aus der Beschichtung kurz aufschmilzt und anschließend durch Abkühlen wieder verfestigt.

Es wurde gefunden, daß die elektrische Leitfähigkeit der TCNQ-Komplexsalzschichten von der Zusammensetzung der für die Beschichtung verwendeten TCNQ-Komplexsalze enthaltenden Druckpasten abhängt und insbesondere vom TCNQ-Komplexsalz/Bindemittel-Verhältnis bestimmt wird. Es wurde gefunden, daß man mit dem üblicherweise in Druckpasten angewendeten Pigment/Bindemittel-Verhältnis von $\leqq 1$ nur Beschichtungen mit unzureichender elektrischer Leitfähigkeit erhält und daß man dieses Verhältnis auf $\geqq 5$ erhöhen muß, um Beschichtungen mit ausreichender elektrischer Leitfähigkeit zu erhalten. Es wurde gefunden, daß Druckpasten, die nur 1/10 der an sich üblichen Bindemittelmenge enthalten, trotzdem zum

Bedrucken, z.B. im Siebdruck verwendbar sind und gedruckte Schichten ergeben, die eine für die weitere Verarbeitung ausreichende mechanische Stabilität und gute Haftfestigkeit aufweisen.

Die Erfindung betrifft daher ein Verfahren zur Erzeugung elektrisch leitender Schichten von TCNQ-Komplexsalzen auf Substraten durch Beschichten der Substrate mit TCNQ-Komplexsalze enthaltenden Druckpasten, das dadurch ge kennzeichnet ist, daß man zum Beschichten Druckpasten verwendet, die als Bindemittel physikalisch trocknende Bindemittel enthalten und in denen das Gewichtsverhältnis TCNQ-Komplexsalze/Bindemittel >5 ist und daß man die aufgedruckten Schichten nach dem Entfernen der organischen Lösungsmittel kurz aufschmilzt und anschließend durch Abkühlen wieder verfestigt.

Die im erfindungsgemäßen Verfahren verwendeten Druckpasten bestehen im wesentlichen aus TCNQ-Komplexsalzen, Bindemittel und organischen Lösungsmitteln; sie können gegebenenfalls noch in Lacken verwendete Netzmittel enthalten, um den Anteil der TCNQ-Komplexsalze zu erhöhen und den Anteil der Bindemittel noch weiter herabzusetzen.

In den erfindungsgemäß zu verwendenden Druckpasten werden vorzugsweise schmelzbare TCNQ-Komplexsalze der Formel

$K^{\oplus}$ (TCNQ $\cdot$ $^{\ominus}$) $(TCNQ)_n$ (I)

eingesetzt, in der

n 0, 1 oder 2, vorzugsweise 1, ist und

$K^{\oplus}$ ein Kation der Formeln

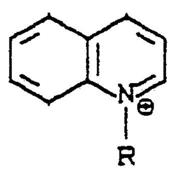
(II)

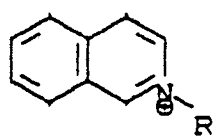
(III)

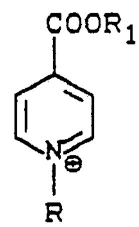
(IV)

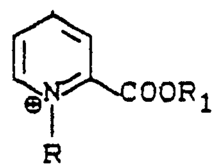
(V)

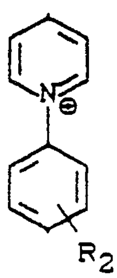
(VI)

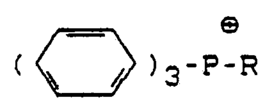
(VII)

in denen

R und $R_1$ unabhängig voneinander für den Rest eines gegebenenfalls substituierten aliphatischen, cycloaliphatischen oder araliphatischen Kohlenwasserstoffs mit 1 bis 30 C-Atomen, vorzugsweise für einen $C_1$-$C_4$-Alkylrest und

$R_2$ für einen den für R und $R_1$ genannten Reste oder einen Alkoxy-Rest mit 1 bis 30 C-Atomen, vorzugsweise für eine Methylgruppe,

stehen.

Bevorzugt sind TCNQ-Komplexe der Formel (I), in der $K^{\oplus}$ für ein Kation der Formeln (III), (IV) oder (VI) steht. Besonders bevorzugt sind die TCNQ-Komplexsalze, die als Kation das N-i-Propyl- oder das N-n-Butyl-isochinoliniumion, das N-Methyl-(4-carbonylethoxy)- und N-Methyl-(2-carbonylethoxy)-pyridiniumion oder das N-Phenyl-pyridiniumion enthalten.

Es können jedoch auch Gemische von schmelzbaren TCNQ-Komplexsalzen und nicht schmelzbaren, elektrisch leitfähigen Feststoffen, wie nicht schmelzbare TCNQ-Komplexsalze, gemahlener Koks, Leitfähigkeitsruße und/oder Metallpulver, verwendet werden, vorausgesetzt daß in diesen Gemischen der Anteil an schmelzbaren TCNQ-Komplexsalzen so hoch ist, daß er in flüssigem Zustand zur Ausbildung einer durchgehenden flüssigen Phase ausreicht.

Außerdem hat es sich bewährt, den schmelzbaren TCNQ-Komplexsalzen oder deren Gemischen mit

nicht schmelzbaren leitfähigen Substanzen 0,1 bis 10 Gew.-%, bezogen auf die Gesamtmenge an TCNQ-Komplexsalzen, TCNQ (Tetracyanochinodimethan) zum Ausgleich von beim Aufschmelzen eintretenden Sublimationsverlusten zuzusetzen.

Der Gehalt der Druckpasten an schmelzbaren TCNQ-Komplexsalzen beträgt 20 bis 75 Gew.-%, vorzugsweise 40 bis 50 Gew.-% bezogen auf das Gesamtgewicht der Druckpaste. Der Teilchendurchmesser der TCNQ-Komplexe liegt im Bereich von 1,5 bis 40 µm.

Als Bindemittel werden physikalisch trocknende, vorzugsweise synthetische organische Bindemittel wie modifizierte Kolophoniumharze, Nitrocellulose, Vinylpolymerisate oder Polyurethane verwendet. Bevorzugt sind organische Polymere wie Polyurethanelastomere und Polymerisate auf Basis von Butylmethacrylat.

Der Gehalt der Druckpasten an Bindemittel richtet sich nach dem Gehalt an schmelzbaren TCNQ-Komplexsalzen in dem Sinne, daß auf einen Gewichtsteil TCNQ-Komplexsalz 0,2 bis 0,025, vorzugsweise 0,05 bis 0,03 Gew.-Teile Bindemittel entfallen. Durch die Mitverwendung von Netzmitteln, wie sie in Lacken verwendet werden, kann der Bindemittelgehalt noch weiter, nämlich auf 0,01 Gewichtsteile je Gewichtsteil TCNQ-Komplexsalz herabgesetzt werden.

Netzmittel, wie sie in Lacken verwendet werden sind z.B. beschrieben in Ullmanns Encyklopädie der Technischen Chemie, 4. Auflage, Bd. 15, p. 677. Geeignet sind Lecithine, z.B. auf Basis Sojalecithin. Bevorzugt sind jedoch anionische Netzmittel, z.B. Ammoniumstearat oder kationische Netzmittel, z.B. Stearylaminchlorid. Besonders bevorzugt sind Umsetzungsprodukte von Polyaminen mit Ölsäure und Triethylphosphat. Die Netzmittel werden in einer Menge von höchstens 5 Gew.-%, bevorzugt in einer Menge von 0 bis 1 Gew.-%, bezogen auf die Gesamtmenge der Paste eingesetzt.

Die in den Druckpasten verwendeten organischen Lösungsmittel sind durch folgende Eigenschaften gekennzeichnet:

Sie sollten das TCNQ-Komplexsalz praktisch nicht lösen, müssen aber das Bindemittel und das Netzmittel lösen, einen Siedepunkt oberhalb von 100 °C, vorzugsweise im Bereich von 120 bis 265 °C und Verdunstungszahlen (bestimmt nach DIN 53 170) oberhalb von 30 aufweisen. Außerdem müssen die organischen Lösungsmittel inert gegenüber den TCNQ-Komplexsalzen sein. Lösungsmittel mit diesen Eigenschaften sind z.B. aliphatische Kohlenwasserstoffe wie Octan, Nonan, Decan, Toluol, Xylol, Mesitylen oder technische Gemische dieser Kohlenwasserstoffe, z.B. handelsübliche aromatische $C_9$-$C_{10}$- oder $C_{12}$-$C_{14}$-Kohlenwasserstoffgemische;

Ester gesättigter Carbonsäuren wie der Essigsäureester des 1-Methoxy-propan-2-ols und des Diethylenglykolmonoethylethers;

aliphatische Ether wie Diethylenglykoldimethylether und Diethylenglykoldiethylether;

cyclische Lactame wie N-Methylpyrrolidon und N-Methylcaprolactam.

Zur Herstellung der erfindungsgemäß zu verwendenden Druckpasten werden die schmelzbaren TCNQ-Komplexsalze oder Gemische dieser Komplexsalze mit nicht schmelzbaren, elektrisch leitfähigen Feststoffen, vorzugsweise nicht schmelzbaren TCNQ-Komplexsalzen (Teilchendurchmesser der Feststoffe 1,5 bis 70 µm, vorzugsweise 1,5 bis 50 µm) mit dem vorgesehenen organischen Lösungs mittel und der Lösung des Bindemittels in dem organischen Lösungsmittel oder der Lösung des Bindemittels und des Netzmittels in dem organischen Lösungsmittel miteinander verrührt bis eine homogene Paste entstanden ist. Diese Paste wird auf das zu beschichtende Substrat aufgedruckt.

Als Substrate, die nach dem erfindungsgemäßen Verfahren beschichtet werden können kommen sowohl Flächengebilde aus Isolatoren wie Glas, Keramik oder organischen Polymeren als auch Metalle wie Kupfer und Aluminium in Betracht.

Das Beschichten der Substrate im erfindungsgemäßen Verfahren kann nach üblichen Druckverfahren, z.B. durch Aufrakeln durch Schablonen (Schablonendruck), Siebdruck oder durch Tiefdruck, vorgenommen werden; vorzugsweise erfolgt das Beschichten durch Siebdruck.

Im Anschluß an das Bedrucken werden die beschichteten Substrate bis zur Gewichtskonstanz getrocknet. Das Trocknen (= Entfernen) des organischen Lösungsmittels aus der aufgedruckten Schicht wird, gegebenenfalls im Vakuum, bei Temperaturen von 20 bis 110 °C vorgenommen.

Zum Aufschmelzen der nach dem Trocknen auf dem Substrat erhaltenen Schicht, wird das beschichtete Substrat für eine kurze Zeit, etwa 1 bis 10 sec, wenige Grade, ewa 5 bis 10 °C, über den Schmelzpunkt des schmelzbaren TCNQ-Komplexsalzes erwärmt. Nach Verflüssigung der aufgedruckten Schicht wird diese durch Abkühlen wieder zum Erstarren gebracht.

Die Erfindung betrifft ferner die in dem erfindungsgemäßen Verfahren verwendeten Druckpasten zum Beschichten von Substraten mit schmelzbaren TCNQ-Komplexsalzen die aus folgenden Komponenten aufgebaut sind:

20 bis 75 Gew.-%, vorzugsweise 40 bis 50 Gew.-%, schmelzbare TCNQ-Komplexsalze oder Gemische dieser Komplexsalze mit nicht schmelzbaren, elektrisch leitfähigen Feststoffen,

0,5 bis 15 Gew.-%, vorzugsweise 1 bis 2 Gew.-% physikalisch trocknende Bindemittel,
0 bis 5 Gew.-%, vorzugsweise 0 bis 1 Gew.-% Netzmittel und
Rest auf 100 Gew.-% organische Lösungsmittel,
alle Gew.-% bezogen auf das Gesamtgewicht der Druckpaste, mit der Maßgabe, daß in der Druckpaste auf 1 Gew.-Teil der schmelzbaren TCNQ-Komplexsalze, oder deren Gemische mit nicht schmelzbaren den elektrischen Strom leitenden Feststoffen nur 0,2 bis 0,025 Gew.-Teile, vorzugsweise 0,05 bis 0,03 Gew.-Teile Bindemittel entfallen und der Anteil der schmelzbaren TCNQ-Komplexsalze in den Gemischen mit den nicht schmelzbaren, elektrisch leitfähigen Feststoffen so hoch ist, daß beim Schmelzen eine durchgehende flüssige Phase entsteht.

Beispiel 1

(a) Herstellung der Druckpaste

125 g N-n-Butylisochinolinium-TCNQ-Komplexsalz (Teilchendurchmesser 1,5 bis 40 µm) werden mit 125 g Propylenglykol-1-methylether-2-acetat zu einem viskosen Brei verrührt. Dieser wird anschließend mit 25 g einer 20 gew.-%igen Lösung eines Polyurethan-Elastomers (Umsetzungsprodukt von Adipinsäure, Neopentylglykol und p,p'-Diphenyl-dimethyl-methan) in Propylenglykol-1-methylether-2-acetat versetzt. Die Mischung wird anschließend durch intensives Rühren homogenisiert.

(b) Verwendung der Druckpaste im Siebdruck

Die nach (a) erhaltene Druckpaste wird mittels einer Hartgummirakel von Hand durch eine Siebschablone mit einer rechteckigen Öffnung von 5 x 1,5 cm (Testschicht zur Bestimmung der Leitfähigkeit) und 5 quadratischen Öffnungen von 5 x 5 mm (Testschichten für die Bestimmung der Randschärfe) auf dünne Keramikplättchen aus Aluminiumoxid (Maße der Plättchen: 5 x 5 x 0,06 cm) gedruckt. Für jeden Druckvorgang wird das Sieb 2 mal mit der Rakel bestrichen. Für die Erzeugung von Doppel- und Dreifachdrucken wird der beschriebene Druckvorgang noch einmal bzw. zweimal wiederholt. Vor jeder Wiederholung des Druckvorganges werden die erhaltenen Beschichtungen etwa 5 min bei 100° C getrocknet.

(c) Herstellung von elektrisch leitenden Schichten

Die bedruckten Keramikplättchen werden anschließend für 10 Sekunden auf eine auf 260° C erhitzte Metallplatte gelegt. Innerhalb von 5 bis 9 Sekunden tritt eine vollständige Verflüssigung der Druckschichten ein. Die Schmelzen werden durch Abkühlen der Keramikplättchen (a) durch Auflegen auf eine Metallplatte mit einer Temperatur von 25° C (schnelle Abkühlung innerhalb von 1 bis 2 Sekunden) oder (b) durch Abkühlen an der Luft (langsame Abkühlung innerhalb von 7 bis 9 Sekunden) wieder verfestigt.

In der nachstehenden Tabelle 1 sind die Dicken und Flächengewiohte der auf diese Weise erhaltenen Schichten zusammengestellt.

Tabelle 1

| | Schichtdicke [µm] | Schichtgewicht [g/m²] |
|---|---|---|
| Einfachdrucke | 20-40 | 20-30 |
| Zweifachdrucke | 50-75 | 60-70 |
| Dreifachdrucke | 80-110 | 105-115 |

(d) Messung des Widerstandes der elektrisch leitenden Schichten

Für diese Bestimmung werden auf die Oberfläche der Testschicht von 5 x 1,5 cm zwei Leitsilberelektroden von 5 mm Breite quer über den Teststreifen aufgebracht, wobei der Abstand von Innenrand zu Innenrand der beiden Elektroden 20 mm beträgt. Die Messung der Widerstände erfolgte mit einer Spannungsquelle von 100 mV. In der nachstehenden Tabelle 2 sind die Dicken der beim ein-, zwei- und dreimaligen Bedrucken erhaltenen Schichten, ihre Widerstände und die aus den Schichtdicken und ihren stände zusammengestellt.

Tabelle 2

| Widerstand [k Ω] | Schichtdicke [µm] | spezifischer Durchgangswiderstand [Ω x cm) |
|---|---|---|
| 13 | 29 | 28 schnelle Abkühlung |
| 8 | 40 | 26 schnelle Abkühlung |
| 9 | 37 | 25 schnelle Abkühlung |
| 7 | 56 | 29 schnelle Abkühlung |
| 1,8 | 101 | 14 schnelle Abkühlung |
| 3,7 | 32 | 8,9 langsame Abkühlung |
| 3,5 | 27 | 7,1 langsame Abkühlung |
| 2,0 | 64 | 9,6 langsame Abkühlung |

Beispiel 2

(a) In das Gemisch aus 50 g Propylenglykol-1-methylether-2-acetat, 7 g Shellsol A (aromatisches Kohlenwasserstoffgemisch im Bereich $C_9$-$C_{10}$), 14 g N-Methylcaprolactam und 12 g einer 20 gew.-%igen Lösung einer Polyurethanelastomers (Umsetzungsprodukt von Adipinsäure, Neopentylglykol und p,p′-Diphenyl-dimethylmethan-diisocyanat) in Propylenglykol-1-methylether-2-acetat werden unter Rühren 62 g N-n-Butyl-isochinolinium-TCNQ (Teilchendurchmesser: 1,5 bis 65 µm) portionsweise eingetragen. Nach vollständiger Homogenisierung der Mischung wird eine viskose, im Siebdruck gut verarbeitbare Druckpaste erhalten.

(b) In das Gemisch aus 38 g Propylenglykol-1-methylether-2-acetat, 25 g Shellsol A und 15 g einer 20 gew.-%igen Lösung von Plexigum P 24 (Bindemittel auf Basis von Polybutylacrylat) in Propylenglykol-1-methylether-2-acetat werden unter Rühren 75 g N-n-Butyl-isochinolinium-[TCNQ$^{\bullet\ominus}$] [TCNQ] (Teilchendurchmesser: 1,5 bis 40 µm) portionsweise eingetragen. Nach vollständigem Homogenisieren des Gemisches wird eine hochviskose Druckpaste erhalten.

(c) In das Gemisch aus 46 g Shellsol R (hocharomatisches Kohlenwasserstoffgemisch, überwiegend im Bereich $C_{12}$-$C_{14}$) und 9 g einer 20 %igen Lösung von Plexigum P 24 (Bindemittel auf Basis Polybutylacrylat) werden unter intensivem Rühren 47 g N-n-Butylisochinolinium-[TCNQ$^{\bullet\ominus}$] [TCNQ] (Teilchendurchmesser: 1,5 bis 40 µm) eingetragen. Nach vollständigem Homogenisieren des Gemisches wird eine viskose Paste erhalten, die sich im Maschinensiebdruck hervorragend verdrucken läßt.

(d) In 265 g einer 3,6 gew.-%igen Lösung von Plexigum P 24 in Shellsol R (hocharomatischer Kohlenwasserstoffgemisch, überwiegend im Bereich $C_{12}$-$C_{14}$) werden unter intensivem Rühren 157 g N-n-Butylisochinolinium-[TCNQ$^{\bullet\ominus}$] [TCNQ] (Teilchendurchmesser: 2 bis 50 µm) und 80 g des Komplexsalzes
$[(C_6H_5)_3PC_3H_7i]^+$ [TCNQ$^{\bullet\ominus}$] [TCNQ]
(Teilchendurchmesser: 5 bis 40 µm) eingetragen.

Nach vollständiger Homogenisierung wird eine viskose, für das Verarbeiten im Siebdruck geeignete Paste erhalten.

Eine gleichwertige Paste wurde erhalten, wenn anstelle der 80 g des Phosphonium-TCNQ-Komplexes 78 g des TCNQ-Komplexes der Formel

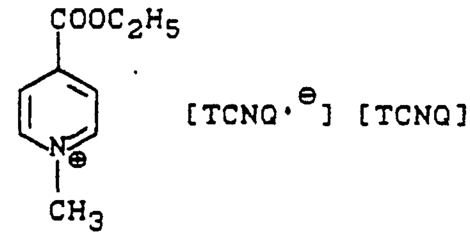

(Teilchendurchmesser: 2 bis 40 µm) verwendet wurden.

Die unter (b) beschriebene Paste wurde in eine Siebdruckmaschine gegeben. Es wurden nacheinander 200 rechteckige Testflächen von 5 x 1,5 cm auf dünne Keramikplättchen aus Aluminiumoxid (Maße: 5 x 5 x 0,06 cm) gedruckt. Es wurden gleichmäßig dicke, scharfkantige Schichten erhalten. Nach dem Trocknen der erhaltenen Beschichtungen bis zur Gewichtskonstanz (Entfernen der organischen Lösungsmittel) lagen die Gewichte der einzelnen Schichten zwischen 27 und 29 g/m². Einige der bedruckten Plättchen wurden nach dem Trocknen erneut bedruckt. Ihre Schichtgewichte lagen nach dem Trocknen der zweiten Schicht zwischen 55 und 58 g/m².

Zum Aufschmelzen wurden die bedruckten Keramikplättchen mit der nicht bedruckten Seite auf eine auf 260 °C erhitzte Metallplatte gelegt. Die Verflüssigung der Druckschichten, erkennbar an der Bildung einer glatten glänzenden Oberfläche, erfolgte innerhalb von 9 Sekunden. Nach einem Verweilen von insgesamt 10 Sekunden auf der Heizplatte, wurden die Keramikplättchen auf eine auf 190 °C erhitzte Metallplatte geschoben. Auf dieser erstarrten die flüssigen Schichten bereits nach 8 Sekunden. Die Verfestigung macht sich am Mattwerden der Oberfläche bemerkbar. Nach dem Erstarren der Schichten wurden die Keramikplättchen auf ein Drahtsieb abgelegt und dort auf Raumtemperatur abgekühlt.

Die elektrische Leitfähigkeit der aufgedruckten Schichten wurde wie in Beispiel 1 (d) beschrieben bestimmt.

Die einfach bedruckten Plättchen wiesen im Durchschnitt einen Widerstand von 5,0 kΩ bzw. einen spezifischen Durchgangswiderstand von 10,9 Ω x cm, die doppelt bedruckten Plättchen einen Widerstand von 1,9 kΩ bzw. einen spezifischen Durchgangswiderstand von 8,8 Ω x cm auf.

Vor dem Schmelzen wiesen die einfach bedruckten Plättchen einen Widerstand von 10.000 kΩ die doppelt bedruckten Plättchen einen Widerstand von 8.500 kΩ auf, d.h. durch den Schmelzvorgang sinkt der Widerstand um den Faktor $10^3$ bis $10^4$.

## Ansprüche

1. Verfahren zur Erzeugung elektrisch leitender Schichten von TCNQ-Komplexsalzen auf Substraten durch Beschichten der Substrate mit schmelzbare TCNQ-Komplexsalze enthaltenden Druckpasten, dadurch gekennzeichnet, daß man zum Beschichten Druckpasten verwendet, die als Bindemittel physikalisch trocknende Bindemittel enthalten und in denen das Gewichtsverhältnis TCNQ-Komplexsalze/Bindemittel >5 ist und daß man die aufgedruckten Schichten nach dem Entfernen der organischen Lösungsmittel kurz aufschmilzt und anschließend durch Abkühlen wieder verfestigt.

2. Verfahren nach Anspruch 1, dadurch gekennzeichnet, daß das Gewichtsverhältnis TCNQ-Komplexsalz/Bindemittel in den Druckpasten >10 ist.

3. Verfahren nach Ansprüchen 1 oder 2, dadurch gekennzeichnet, daß man den schmelzbaren TCNQ-Komplexsalzen 0,1 bis 10 Gew.-% Tetracyanochinodimethan, bezogen auf die Gesamtmenge an TCNQ-Komplexsalzen, zumischt.

4. Druckpasten zum Beschichten von Substraten mit schmelzbaren TCNQ-Komplexsalzen enthaltend
20 bis 75 Gew.-% schmelzbare TCNQ-Komplexsalze oder Gemische dieser Komplexe mit nicht schmelzbaren, elektrisch leitfähigen Feststoffen, 0,5 bis 15 Gew.-% physikalisch trocknende Bindemittel,
0 bis 5 Gew.-% Netzmittel und
Rest auf 100 Gew.-% organische Lösungsmittel,
alle Gew.-% bezogen auf das Gesamtgewicht der Druckpaste, mit der Maßgabe, daß in der Druckpaste auf 1 Gew.-Teil der schmelzbaren TCNQ-Komplexsalze, oder des Gemisches dieser Salze mit nicht schmelzbaren elektrisch leitfähigen Feststoffen, nur 0,2 bis 0,025 Gew.-Teile Bindemittel entfallen und der Anteil der schmelzbaren TCNQ-Komplexsalze in den Gemischen mit den nicht schmelzbaren elektrisch leitfähigen Feststoffen so hoch ist, daß beim Schmelzen eine durchgehende flüssige Phase entsteht.

5. Druckpasten nach Anspruch 4 enthaltend 40 bis 50 Gew.-% schmelzbare TCNQ-Komplexsalze oder

Gemische dieser Komplexsalze mit nicht schmelzbaren elektrisch leitfähigen Feststoffen,
1 bis 2 Gew.-% physikalisch trocknende Bindemittel,
0 bis 1 Gew.-% Netzmittel,
Rest auf 100 Gew.-% organische Lösungsmittel alle Gew.-% bezogen auf das Gesamtgewicht der Druckpaste, mit der Maßgabe, daß in dieser auf 1 Gew.-Teil der schmelzbaren TCNQ-Komplexsalze oder der Gemische dieser Salze mit nicht schmelzbaren elektrisch leitfähigen Feststoffen nur 0,05 bis 0,025 Gew.-Teile Bindemittel entfallen und der Anteil der schmelzbaren TCNQ-Komplexsalze in den Gemischen so hoch ist, daß beim Schmelzen eine durchgehende flüssige Phase entsteht.

6. Druckpasten nach Anspruch 4 enthaltend 40 bis 50 Gew.-% schmelzbare TCNQ-Komplexsalze,
1 bis 2 Gew.-% physikalisch trocknende Bindemittel,
0 bis 1 Gew.-% Netzmittel,
Rest auf 100 Gew.-% organische Lösungsmittel, alle Gew.-% bezogen auf das Gesamtgewicht der Druckpaste, mit der Maßgabe, daß in dieser auf 1 Gew.-Teil schmelzbare TCNQ-Komplexsalze nur 0,05 bis 0,025 Gew.-Teile Bindemittel entfallen.